# EUROPEAN PATENT SPECIFICATION

(11) **EP 3 423 278 B1**
(45) Date of publication and mention of the grant of the patent: **29.12.2021**
(21) Application number: 17760913.8
(22) Date of filing: 03.03.2017
(51) Int. Cl.: B22F 3/00, H05K 1/02, H05K 3/12, B22F 10/10, B33Y 70/00, B33Y 10/00, H05K 3/00

(54) **ADDITIVE MANUFACTURING PROCESSES UTILIZING METAL NANOPARTICLES**
VERFAHREN ZUR GENERATIVEN FERTIGUNG UNTER VERWENDUNG VON METALLNANOPARTIKELN
PROCÉDÉ DE FABRICATION ADDITIVE UTILISANT DES NANOPARTICULES MÉTALLIQUES

(30) Priority: 04.03.2016 US 201662304093 P; 01.03.2017 US 201715447062
(43) Date of publication of application: 09.01.2019
(73) Proprietor: Lockheed Martin Corporation, Bethesda, Maryland 20817-1877 (US)
(72) Inventor: HANNI, David Guy, Littleton, CO 80127 (US); BEFFA, James Charles, Menlo Park, CA 94025 (US); GEYER, Robert Barrett, Campbell, CA 95008 (US); LOH, Lawrence C., Saratoga, CA 95070 (US); PARENT, Kelly M., Sandy, UT 84093 (US); ZINN, Alfred A., Palo Alto, CA 94303 (US)
(74) Representative: Epping - Hermann - Fischer
(86) International application number: PCT/US2017/020698
(87) International publication number: WO 2017/152075

(56) References cited:
- US-A1- 2006 072 944
- US-A1- 2011 304 520
- US-A1- 2012 025 365
- US-A1- 2012 251 381
- US-A1- 2015 197 063
- US-A1- 2015 197 063
- US-A1- 2016 172 741
- US-A1- 2016 204 494
- US-B1- 6 379 745
- US-B1- 6 379 745
- YOUNGIL LEE ET AL: "Large-scale synthesis of copper nanoparticles by chemically controlled reduction for applications of inkjet-printed electronics", NANOTECHNOLOGY, IOP, BRISTOL, GB, vol. 19, no. 41, 15 October 2008 (2008-10-15), page 415604, XP020144684, ISSN: 0957-4484, DOI: 10.1088/0957-4484/19/41/415604

## Description

### CROSS-REFERENCE TO RELATED APPLICATIONS

The present application claims the benefit of priority under 35 U.S.C. § 119 of U.S. Provisional Patent Application 62/304,093, filed on March 4, 2016.

### FIELD

The present disclosure generally relates to additive manufacturing processes and, more specifically, to additive manufacturing processes utilizing metal nanoparticles.

### BACKGROUND

Three-dimensional (3-D) printing, also known as additive manufacturing, is a rapidly growing technology area that generally operates by depositing small droplets or streams of a melted or softened printing material in precise deposition locations under control of a computer. Printing materials commonly employed in conventional additive manufacturing processes include polymers and other dielectric materials that are easily melted and solidified. Deposition of the printing material results in gradual, layer-by-layer buildup of an object, which can be in any number of complex shapes. Additive manufacturing processes are frequently employed in rapid prototyping programs due to their ability to provide objects much more expediently than can traditional manufacturing processes. Although additive manufacturing processes are commonly referred to as 3-D printing processes, both two- and three-dimensional objects can be produced by these techniques.

One of the shortcomings associated with conventional additive manufacturing processes is their inability to introduce contiguous electrically conductive pathways in a printed object. While discrete metal particles can sometimes be deposited using conventional additive manufacturing equipment, the metal particles remain individualized in the printed object rather than forming a contiguous feature therein, since the metal particles cannot be liquefied (reflowed) without compromising the shape or integrity of the dielectric material in the object. Specifically, the melting points of most metals are well above the softening temperature of the polymers and other dielectric materials that are commonly used in conventional additive manufacturing processes.

As an example, the document Youngil Lee et al: "Large-scale synthesis of copper nanoparticles by chemically controlled reduction for applications of inkjet-printed electronics", Nanotechnology, IOP, Bristol discloses a method of printing electronic conductive 3D-structures of electronic devices using pastes based on metallic copper nanoparticles, whereby a second, dielectric component is manufactured by conventional methods. So deforming effects of polymer materials may be avoided.

Similar copper nanoparticles as used in the method above and their properties are further described in the patent application US 2012/0251381 A1.

The patent application US 2015/197063 A1 discloses a method of printing both, electronic conductive and dielectric components by one printing device. However, the disclosed method is only conductible with rare appropriate materials, since otherwise the polymer structures may break at the elevated temperatures used for printing metallic materials.

Direct deposition of liquefied metals is similarly incompatible with conventional additive manufacturing equipment due to the high temperatures involved.

The patent US 6,379,745 B1 discloses an additive manufacturing method using metal powders with specified characteristics allowing a low temperature printing process.

However, even in the limited instances where direct deposition of a low-melting liquefied metal might take place, deformation of a polymer or other dielectric material can still occur upon contact with the liquefied metal.

Although traditional manufacturing approaches can be used to produce contiguous metal traces in an object containing a dielectric material, such manufacturing approaches can lack the flexibility associated with additive manufacturing processes. For example, traditional manufacturing approaches can be incapable of producing the breadth of object shapes that are accessible through additive manufacturing processes, especially in a cost-effective manner. Current methodologies in traditional manufacturing approaches can involve etching out a desired pattern from a metal-coated substrate and then lining up and bonding multiple layers together, including from a metal-coated substrate and then lining up and bonding multiple layers together, including dielectric material layers. This approach can be tedious, time-consuming and expensive, and complex object geometries can still be very difficult to produce.

In view of the foregoing, improved techniques for defining contiguous metal traces in additive manufacturing processes would be of significant interest in the art. The present disclosure satisfies this need and provides related advantages as well.

### SUMMARY

In various embodiments, additive manufacturing processes of the present disclosure can include: providing a first printing composition containing a plurality of metal nanoparticles and a second printing composition containing a dielectric material, wherein the plurality of metal nanoparticles is selected from a group consisting of tin nanoparticles, copper nanoparticles, aluminum nanoparticles, palladium nanoparticles, silver nanoparticles, iron nanoparticles, cobalt nanoparticles, nickel nanoparticles, titanium nanoparticles, zirconium nanoparticles, hafnium nanoparticles, and tantalum nanoparticles and the dielectric material comprises at least one of polyketones, polystrenes, acrylonitrile-butadiene-styrene copolymer, polyetheretherketones, polyamides, polyolefins, polyethylene, polypropylene, polyesters, polyurethanes, polyacrylonitriles, polycarbonates, polyetherimines, polyethyleneimine, polyethylene terephthalate, polyvinyl chloride, polyetherimine, polycarbonate, and polyetherimine;
depositing at least a portion of the second printing composition above a softening temperature of the dielectric material to form a first portion of an object having a desired shape; cooling the first portion of the object below the softening temperature and above a fusion temperature of the metal nanoparticles before depositing the first printing composition; depositing the first printing composition on the first portion of the object, the metal nanoparticles are unconsolidated with one another while being deposited, and maintaining the deposited first printing composition above a fusion temperature of the metal nanoparticles and below a softening temperature of the dielectric material during depositing the first printing composition to define one or more contiguous metal traces in the object. The one or more contiguous metal traces include metal nanoparticles that have been at least partially fused together with one another in a defined shape.

The foregoing has outlined rather broadly the features of the present disclosure in order that the detailed description that follows can be better understood. Additional features and advantages of the disclosure will be described hereinafter.

### BRIEF DESCRIPTION OF THE DRAWINGS

For a more complete understanding of the present disclosure, and the advantages thereof, reference is now made to the following descriptions to be taken in conjunction with the accompanying drawings describing specific embodiments of the disclosure, wherein:
FIGURES 1 and 2 show presumed structures of metal nanoparticles having a surfactant coating thereon;
FIGURE 3 shows an illustrative schematic of an additive manufacturing process in which metal nanoparticles are deposited and consolidated following deposition of a polymer material; and
FIGURE 4 shows an illustrative schematic of an additive manufacturing process of an object in which metal nanoparticles and a polymer material are deposited at separate locations.

### DETAILED DESCRIPTION

The present disclosure is directed, in part, to printing compositions containing metal nanoparticles that are suitable for use in additive manufacturing processes. The present disclosure is also directed, in part, to additive manufacturing processes utilizing metal nanoparticles. The present disclosure is also directed, in part, to objects fabricated using additive manufacturing processes utilizing metal nanoparticles, particularly antennas, which may have a complex shape.

Current additive manufacturing processes are limited in their ability to introduce contiguous electrically conductive pathways in an object, particularly those also containing a polymer or similar dielectric material. Specifically, the polymers and other dielectric materials that are commonly used in conventional additive manufacturing processes undergo softening at temperatures (*i.e.,* at the glass transition temperature) that are much lower than the melting points of most metals, particularly high-conductivity metals such as copper. As such, the conditions needed for liquefying metals to form contiguous metal traces in an object are generally incompatible with the polymers and other dielectric materials that are also present, not to mention incompatibility with the additive manufacturing equipment itself. Specifically, at the temperatures needed to liquefy metals, polymers and other dielectric materials can undergo deformation to compromise an object's integrity and/or experience thermal degradation. Conventional manufacturing techniques, such as those employing silver inks or machined copper traces, are similarly limited in their inability to produce the wide range of complex shapes that are accessible through additive manufacturing processes, such as those disclosed herein.

The present inventors discovered that printing compositions containing metal nanoparticles (also referred to herein as nanoparticle inks or nanoparticle pastes) can be used in conjunction with additive manufacturing processes, including those in which readily softened polymers and other dielectric materials are also present. Using metal nanoparticles in this manner can allow a number of advantages to be realized by exploiting the advantageous properties of the metal nanoparticles, as discussed hereinafter. In brief, printing compositions containing metal nanoparticles can provide access to objects containing one or more contiguous metal traces in or on a dielectric material, which can otherwise be difficult to produce in conventional manufacturing processes and/or be completely inaccessible in conventional additive manufacturing processes. The components of the printing compositions can be tailored to meet the requirements of a particular additive manufacturing process and/or additively manufactured object.

Metal nanoparticles exhibit a number of properties that can differ significantly from those of the corresponding bulk metal. One property of metal nanoparticles that can be of particular importance is nanoparticle fusion or consolidation that occurs at the metal nanoparticles' fusion temperature. As used herein, the term "fusion temperature" refers to the temperature at which a metal nanoparticle liquefies, thereby giving the appearance of melting. As used herein, the terms "fusion" or "consolidation" synonymously refer to the coalescence or partial coalescence of metal nanoparticles with one another to form a larger mass, such as a contiguous metal trace having a defined shape. As used herein, the term "contiguous metal trace" refers to a plurality of metal nanoparticles that are deposited in a desired shape in an object and are at least partially fused together with one another to define a continuous metallic path. That is, there is connectivity between the metal nanoparticles following heating above the fusion temperature. Upon decreasing in size, particularly below about 20 nm in equivalent spherical diameter, the temperature at which metal nanoparticles undergo liquefication drops dramatically from that of the corresponding bulk metal. For example, copper nanoparticles having a size of about 20 nm or less, and more particular 20 nm or less, can have fusion temperatures of about 220°C or below, or about 200°C or below, in comparison to bulk copper's melting point of 1083°C. Thus, the consolidation of metal nanoparticles taking place at the fusion temperature can allow objects containing bulk metal to be fabricated at significantly lower processing temperatures than when working directly with the bulk metal itself. The low fusion temperatures of copper nanoparticles and similar metal nanoparticles are frequently lower than the temperatures at which polymers and other dielectric materials commonly used in additive manufacturing processes undergo softening. As such, metal nanoparticles can be consolidated in an object to form a contiguous metal trace without decomposing or deforming a polymer or other dielectric material, thereby allowing ready access to objects having a one or more defined conductive pathways therein.

After consolidation of the metal nanoparticles takes place to define one or more contiguous metal traces, continued deposition of the polymer or other dielectric material can continue to complete the fabrication of the object. Since the metal nanoparticles have a melting point at or near that of the corresponding bulk metal after consolidation takes place, continued deposition of the polymer or other dielectric material does not significantly deform the metal after consolidation has taken place. Furthermore, in some embodiments, metal nanoparticles and dielectric materials can be deposited upon one another in repeating cycles to form multi-layered objects.

By utilizing printing compositions containing metal nanoparticles in additive manufacturing processes, a reduction in process steps and decreased object sizes and linewidths can be realized. In addition, a wide range of complex shapes can be constructed. In some instances, contiguous metal traces lacking a dielectric material can be fabricated by forming an initial object and then etching or dissolving the dielectric material away to leave being at least partially fused metal nanoparticles in a complex shape. Regardless of the nature of the objects that are prepared through the additive manufacturing processes, the print compositions can serve as essentially drop-in replacements for conventional printing compositions.

Since the additively manufactured objects of the present disclosure contain one or more contiguous metal traces, they can be configured as an antenna in some embodiments. Depending upon the particular application for which an antenna is intended, the shape of the antenna can vary significantly. The wide variance in possible antenna shapes can be easily accommodated by the additive manufacturing processes of the present disclosure. Specifically, the additive manufacturing processes described herein can allow a wide range of antennas having various complex shapes, contour and tuning to be produced. For example, the architecture of antennas and electrical circuits produced through additive manufacturing can be varied to tune to a particular wavelength of electromagnetic radiation and/or to place lobes or nodes in a particular location within the antenna structure. Since the additive manufacturing processes described herein can provide ready access to such a wide range of object shapes, the presently described processes can extend the range of available antennas for various applications, some of which are inaccessible by current manufacturing techniques.

Copper nanoparticles can be particularly desirable metal nanoparticles for inclusion in the printing compositions and additive manufacturing processes disclosed herein due to its reasonably low cost and high electrical conductivity. Copper-based antennas and electrical circuit lines can be particularly desirable for these reasons. Fabricating complex copper-based antennas through conventional manufacturing processes can be difficult, such as through processes employing copper-clad dielectric sheets.

In addition, conventional manufacturing processes can be difficult to implement upon curved or other non-planar surfaces. Specifically, surface conformance can be difficult to achieve. In contrast, the additive manufacturing processes disclosed herein can be readily performed at low temperatures on curved or other non-planar surfaces to realize a conformal deposition of copper nanoparticles or other metal nanoparticles upon the surface. Following consolidation of the metal nanoparticles, the resulting contiguous metal trace can be similarly conformally disposed.

Accordingly, in various embodiments, additive manufacturing processes of the present disclosure can include: providing a first printing composition containing a plurality of metal nanoparticles and a second printing composition containing a dielectric material, depositing the first printing composition and the second printing composition together with one another to form an object having a desired shape in which the metal nanoparticles are unconsolidated with one another after being deposited, and heating the object above a fusion temperature of the metal nanoparticles and below a softening temperature of the dielectric material to define one or more contiguous metal traces in the object. The one or more contiguous metal traces include metal nanoparticles that have been at least partially fused together with one another in a defined shape.

In some embodiments, the first and second printing compositions can include a solvent. Suitable solvents are not considered to be particularly limited. In other embodiments, the second printing composition can lack a solvent and instead represent a melt or partial melt of the dielectric material. Particular dielectric materials that can be suitable in this regard are also not considered to be particularly limited, and illustrative examples are provided hereinbelow. Additional details concerning the first printing composition are provided hereinafter.

Before further discussing more particular aspects of the present disclosure, a brief description of metal nanoparticles, particularly copper nanoparticles, will first be provided. As mentioned above, a distinguishing feature of metal nanoparticles is their low fusion temperature, which allows the advantageous additive manufacturing processes described herein to be realized. Additional disclosure directed to metal nanoparticle pastes and other suitable printing compositions follows thereafter.

As used herein, the term "metal nanoparticle" refers to metal particles that are about 100 nm or less in size, without particular reference to the shape of the metal particles.

As used herein, the term "organic matrix" refers to a continuous fluid phase containing one or more organic compounds and having the ability to flow, with or without the application of a force thereto.

As used herein, the term "micron-scale metal particles" refers to metal particles that are about 100 nm or greater in size in at least one dimension.

The terms "consolidate," "consolidation" and other variants thereof are used interchangeably herein with the terms "fuse," "fusion" and other variants thereof.

As used herein, the terms "partially fused," "partial fusion," and other derivatives and grammatical equivalents thereof refer to the partial coalescence of metal nanoparticles with one another. Whereas totally fused metal nanoparticles retain essentially none of the structural morphology of the original unfused metal nanoparticles (*i*.*e*., they resemble bulk metal with minimal grain boundaries), partially fused metal nanoparticles retain at least some of the structural morphology of the original unfused metal nanoparticles. The properties of partially fused metal nanoparticles can be intermediate between those of the corresponding bulk metal and the original unfused metal nanoparticles. In some embodiments, fully dense contiguous metal traces can be obtained in the additively manufactured objects disclosed herein. In other embodiments, the contiguous metal traces can have less than about 10% porosity or less than about 20% porosity in an amount above full densification (*i*.*e*., 0% porosity).

A number of scalable processes for producing bulk quantities of metal nanoparticles in a targeted size range have been developed. Most typically, such processes for producing metal nanoparticles take place by reducing a metal precursor in the presence of one or more surfactants. The metal nanoparticles can then be isolated and purified from the reaction mixture by common isolation techniques. Following isolation, the metal nanoparticles can be incorporated in the printing compositions described herein (*i*.*e*., the first printing composition). These compositions can be further tailored for compatibility with the equipment used in additive manufacturing processes.

Any suitable technique can be employed for forming the metal nanoparticles used in the additive manufacturing processes described herein. Metal nanoparticles can be fabricated in a narrow size range by reduction of a metal salt in a solvent in the presence of a suitable surfactant system, which can include one or more different surfactants. Further description of suitable surfactant systems follows below. Without being bound by any theory or mechanism, it is believed that the surfactant system can mediate the nucleation and growth of the metal nanoparticles, limit surface oxidation of the metal nanoparticles, and/or inhibit metal nanoparticles from extensively aggregating with one another prior to being at least partially fused together. Suitable organic solvents for solubilizing metal salts and forming metal nanoparticles can include, for example, formamide, N,N-dimethylformamide, dimethyl sulfoxide, dimethylpropylene urea, hexamethylphosphoramide, tetrahydrofuran, and glyme, diglyme, triglyme, and tetraglyme. Reducing agents suitable for reducing metal salts and promoting the formation of metal nanoparticles can include, for example, an alkali metal in the presence of a suitable catalyst (*e*.*g*., lithium naphthalide, sodium naphthalide, or potassium naphthalide) or borohydride reducing agents (*e*.*g*., sodium borohydride, lithium borohydride, potassium borohydride, or tetraalkylammonium borohydrides).

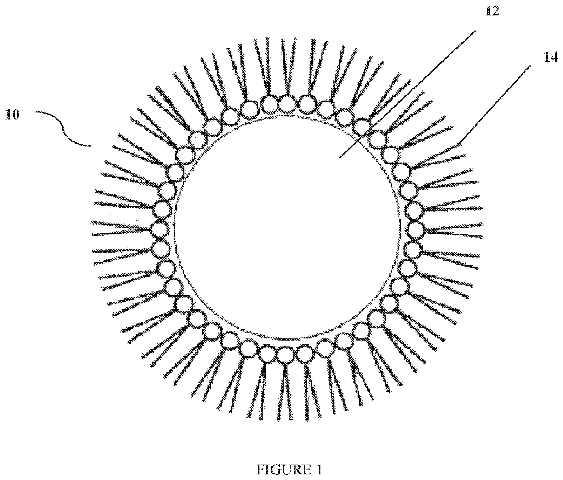

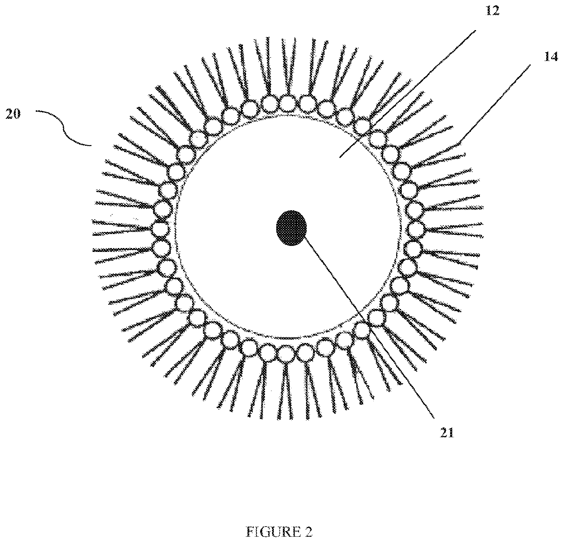

FIGURES 1 and 2 show presumed structures of metal nanoparticles having a surfactant coating thereon. As shown in FIGURE 1, metal nanoparticle 10 includes metallic core 12 and surfactant layer 14 overcoating metallic core 12. Surfactant layer 14 can contain any combination of surfactants, as described in more detail below. Metal nanoparticle 20, shown in FIGURE 2, is similar to that depicted in FIGURE 1, except metallic core 12 is grown about nucleus 21, which can be a metal that is the same as or different than that of metallic core 12. Because nucleus 21 is buried deep within metallic core 12 in metal nanoparticle 20, it is not believed to significantly affect the overall nanoparticle properties. In some embodiments, the nanoparticles can have an amorphous morphology.

As discussed above, the metal nanoparticles have a surfactant coating containing one or more surfactants upon their surface. The surfactant coating can be formed on the metal nanoparticles during their synthesis. The surfactant coating is generally lost during consolidation of the metal nanoparticles upon heating above the fusion temperature, which results in formation of a contiguous metal trace within an object. Formation of a surfactant coating upon metal nanoparticles during their syntheses can desirably limit the ability of the metal nanoparticles to fuse to one another, limit agglomeration of the metal nanoparticles, and promote the formation of a population of metal nanoparticles having a narrow size distribution.

Suitable metal nanoparticles include tin nanoparticles, copper nanoparticles, aluminum nanoparticles, palladium nanoparticles, silver nanoparticles, iron nanoparticles, cobalt nanoparticles, nickel nanoparticles, titanium nanoparticles, zirconium nanoparticles, hafnium nanoparticles, tantalum nanoparticles. For antenna and electronics applications, copper is a particularly desirable metal due to its low cost, strength, and excellent electrical and thermal conductivity values.

In various embodiments, the surfactant system present within the metal nanoparticles can include one or more surfactants. The differing properties of various surfactants can be used to tailor the properties of the metal nanoparticles. Factors that can be taken into account when selecting a surfactant or combination of surfactants for inclusion upon the metal nanoparticles can include, for example, ease of surfactant dissipation from the metal nanoparticles during nanoparticle fusion, nucleation and growth rates of the metal nanoparticles, the metal component of the metal nanoparticles, and the like.

In some embodiments, an amine surfactant or combination of amine surfactants, particularly aliphatic amines, can be present upon the metal nanoparticles. Amine surfactants can be particularly desirable for use in conjunction with copper nanoparticles. In some embodiments, two amine surfactants can be used in combination with one another. In other embodiments, three amine surfactants can be used in combination with one another. In more specific embodiments, a primary amine, a secondary amine, and a diamine chelating agent can be used in combination with one another. In still more specific embodiments, the three amine surfactants can include a long chain primary amine, a secondary amine, and a diamine having at least one tertiary alkyl group nitrogen substituent. Further disclosure regarding suitable amine surfactants follows hereinafter.

In some embodiments, the surfactant system can include a primary alkylamine. In some embodiments, the primary alkylamine can be a C₂ - C₁₈ alkylamine. In some embodiments, the primary alkylamine can be a C₇ - C₁₀ alkylamine. In other embodiments, a C₅ - C₆ primary alkylamine can also be used. Without being bound by any theory or mechanism, the exact size of the primary alkylamine can be balanced between being long enough to provide an effective inverse micelle structure during synthesis versus having ready volatility and/or ease of handling during nanoparticle consolidation. For example, primary alkylamines with more than 18 carbons can also be suitable for use in the present embodiments, but they can be more difficult to handle because of their waxy character. C₇ - C₁₀ primary alkylamines, in particular, can represent a good balance of desired properties for ease of use.

In some embodiments, the C₂ - C₁₈ primary alkylamine can be n-hexylamine, n-heptylamine, n-octylamine, n-nonylamine, or n-decylamine, for example. While these are all straight chain primary alkylamines, branched chain primary alkylamines can also be used in other embodiments. For example, branched chain primary alkylamines such as, for example, 7-methyloctylamine, 2-methyloctylamine, or 7-methylnonylamine can be used. In some embodiments, such branched chain primary alkylamines can be sterically hindered where they are attached to the amine nitrogen atom. Non-limiting examples of such sterically hindered primary alkylamines can include, for example, t-octylamine, 2-methylpentan-2-amine, 2-methylhexan-2-amine, 2-methylheptan-2-amine, 3 -ethyloctan-3 -amine, 3-ethylheptan-3-amine, 3-ethylhexan-3-amine, and the like. Additional branching can also be present. Without being bound by any theory or mechanism, it is believed that primary alkylamines can serve as ligands in the metal coordination sphere but be readily dissociable therefrom during metal nanoparticle consolidation.

In some embodiments, the surfactant system can include a secondary amine. Secondary amines suitable for forming metal nanoparticles can include normal, branched, or cyclic C₄ - C₁₂ alkyl groups bound to the amine nitrogen atom. In some embodiments, the branching can occur on a carbon atom bound to the amine nitrogen atom, thereby producing significant steric encumbrance at the nitrogen atom. Suitable secondary amines can include, without limitation, dihexylamine, diisobutylamine, di-t-butylamine, dineopentylamine, di-t-pentylamine, dicyclopentylamine, dicyclohexylamine, and the like. Secondary amines outside the C₄ - C₁₂ range can also be used, but such secondary amines can have undesirable physical properties such as low boiling points or waxy consistencies that can complicate their handling.

In some embodiments, the surfactant system can include a chelating agent, particularly a diamine chelating agent. In some embodiments, one or both of the nitrogen atoms of the diamine chelating agent can be substituted with one or two alkyl groups. When two alkyl groups are present on the same nitrogen atom, they can be the same or different. Further, when both nitrogen atoms are substituted, the same or different alkyl groups can be present. In some embodiments, the alkyl groups can be C₁ - C₆ alkyl groups. In other embodiments, the alkyl groups can be C₁ - C₄ alkyl groups or C₃ - C₆ alkyl groups. In some embodiments, C₃ or higher alkyl groups can be straight or have branched chains. In some embodiments, C₃ or higher alkyl groups can be cyclic. Without being bound by any theory or mechani sm, it is believed that diamine chelating agents can facilitate metal nanoparticle formation by promoting nanoparticle nucleation.

In some embodiments, suitable diamine chelating agents can include N,N'-dialkylethylenediamines, particularly C₁ - C₄ N,N'-dialkylethyl enediamines. The corresponding methylenediamine, propylenediamine, butylenediamine, pentylenediamine or hexylenediamine derivatives can also be used. The alkyl groups can be the same or different. C₁ - C₄ alkyl groups that can be present include, for example, methyl, ethyl, propyl, and butyl groups, or branched alkyl groups such as isopropyl, isobutyl, s-butyl, and t-butyl groups. Illustrative N,N'-dialkylethylenediamines that can be suitable for inclusion upon metal nanoparticles include, for example, N,N'-di-t-butylethylenediamine, N,N'-diisopropylethylenediamine, and the like.

In some embodiments, suitable diamine chelating agents can include N,N,N',N'-tetraalkylethylenediamines, particularly C₁ - C₄ N,N,N',N'-tetraalkylethylenediamines. The corresponding methylenediamine, propylenediamine, butylenediamine, pentylenediamine or hexylenediamine derivatives can also be used. The alkyl groups can again be the same or different and include those mentioned above. Illustrative N,N,N',N'-tetraalkylethylenediamines that can be suitable for use in forming metal nanoparticles include, for example, N,N,N',N'-tetramethylethylenediamine, N,N,N',N'-tetraethylethylenediamine, and the like.

Surfactants other than aliphatic amines can also be present in the surfactant system. In this regard, suitable surfactants can include, for example, pyridines, aromatic amines, phosphines, thiols, or any combination thereof. These surfactants can be used in combination with an aliphatic amine, including those described above, or they can be used in a surfactant system in which an aliphatic amine is not present. Further disclosure regarding suitable pyridines, aromatic amines, phosphines, and thiols follows below.

Suitable aromatic amines can have a formula of ArNR¹R², where Ar is a substituted or unsubstituted aryl group and R¹ and R² are the same or different. R¹ and R² can be independently selected from H or an alkyl or aryl group containing from 1 to about 16 carbon atoms. Illustrative aromatic amines that can be suitable for use in forming metal nanoparticles include, for example, aniline, toluidine, anisidine, N,N-dimethylaniline, N,N-diethylaniline, and the like. Other aromatic amines that can be used in conjunction with metal nanoparticles can be envisioned by one having ordinary skill in the art.

Suitable pyridines can include both pyridine and its derivatives. Illustrative pyridines that can be suitable for use inclusion upon metal nanoparticles include, for example, pyridine, 2-methylpyridine, 2,6-dimethylpyridine, collidine, pyridazine, and the like. Chelating pyridines such as bipyridyl chelating agents may also be used. Other pyridines that can be used in conjunction with metal nanoparticles can be envisioned by one having ordinary skill in the art.

Suitable phosphines can have a formula of PR₃, where R is an alkyl or aryl group containing from 1 to about 16 carbon atoms. The alkyl or aryl groups attached to the phosphorus center can be the same or different. Illustrative phosphines that can be present upon metal nanoparticles include, for example, trimethylphosphine, triethylphosphine, tributylphophine, tri-t-butylphosphine, trioctylphosphine, triphenylphosphine, and the like. Phosphine oxides can also be used in a like manner. In some embodiments, surfactants that contain two or more phosphine groups configured for forming a chelate ring can also be used. Illustrative chelating phosphines can include 1,2-bisphosphines, 1,3-bisphosphines, and bis-phosphines such as BINAP, for example. Other phosphines that can be used in conjunction with metal nanoparticles can be envisioned by one having ordinary skill in the art.

Suitable thiols can have a formula of RSH, where R is an alkyl or aryl group having from about 4 to about 16 carbon atoms. Illustrative thiols that can present upon metal nanoparticles include, for example, butanethiol, 2-methyl-2-propanethiol, hexanethiol, octanethiol, benzenethiol, and the like. In some embodiments, surfactants that contain two or more thiol groups configured for forming a chelate ring can also be used. Illustrative chelating thiols can include, for example, 1,2-dithiols (*e*.*g*., 1,2-ethanethiol) and 1,3-dithiols *(e.g.,* 1,3-propanethiol). Other thiols that can be used in conjunction with metal nanoparticles can be envisioned by one having ordinary skill in the art.

The metal nanoparticles described hereinabove can be incorporated within printing compositions containing a solvent and/or various additional additives. The additives can be tailored for compatibility with additive manufacturing processes. Illustrative disclosure regarding the printing compositions, which may be referred to herein as nanoparticle paste formulations or nanoparticle inks, follows hereinafter.

Highly workable and dispensable nanoparticle paste formulations or inks can be prepared by dispersing as-produced metal nanoparticles in an organic matrix containing one or more organic solvents and various other optional components. As used herein, the terms "nanoparticle paste formulation" and "nanoparticle paste composition" are used interchangeably with the term "printing composition" and refer synonymously to a fluid composition containing dispersed metal nanoparticles that is suitable for use in additive manufacturing processes. Use of the term "paste" does not necessarily imply an adhesive function of the paste alone. Through judicious choice of the organic solvent(s) and other additives, the loading of metal nanoparticles and the like, the dispensation of the printing compositions with additive manufacturing equipment can be promoted. In this regard, the metal nanoparticles can be present in the same printing composition as the dielectric material, or the dielectric material and the metal nanoparticles can be deposited from different printing compositions.

Cracking can sometimes occur during consolidation of the metal nanoparticles. One way in which the printing compositions can promote a decreased degree of cracking and void formation following metal nanoparticle consolidation is by maintaining a high solids content. More particularly, in some embodiments, the printing compositions can contain at least about 30% metal nanoparticles by weight, particularly about 30% to about 90% metal nanoparticles by weight of the printing composition, or about 50% to about 90% metal nanoparticles by weight of the printing composition, or about 70% to about 90% metal nanoparticles by weight of the printing composition. Moreover, in some embodiments, small amounts (*e*.*g*., about 0.01% to about 15% by weight of the printing composition) of micron-scale metal particles can be present in addition to the metal nanoparticles. Such micron-scale metal particles can desirably promote the fusion of metal nanoparticles into a contiguous metal trace and further reduce the incidence of cracking. Instead of being liquefied and undergoing direct consolidation, the micron-scale metal particles can simply become joined together upon being contacted with liquefied metal nanoparticles that have been raised above their fusion temperature, thereby forming a contiguous metal trace. These factors can reduce the porosity of the metal trace obtained after the metal nanoparticles have been bonded or fused together.

Decreased cracking and void formation during metal nanoparticle consolidation can also be promoted by judicious choice of the solvent(s) forming the organic matrix of the printing compositions. A tailored combination of organic solvents can desirably decrease the incidence of cracking and void formation. More particularly, an organic matrix containing one or more hydrocarbons, one or more alcohols, one or more amines, and one or more organic acids can be especially effective for this purpose. Without being bound by any theory or mechanism, it is believed that this combination of organic solvents can facilitate the removal and sequestration of surfactant molecules surrounding the metal nanoparticles during consolidation, such that the metal nanoparticles can more easily fuse together with one another. More particularly, it is believed that hydrocarbon and alcohol solvents can passively solubilize surfactant molecules released from the metal nanoparticles by Brownian motion and reduce their ability to become re-attached thereto. In concert with the passive solubilization of surfactant molecules, amine and organic acid solvents can actively sequester the surfactant molecules through a chemical interaction such that they are no longer available for recombination with the metal nanoparticles.

Further tailoring of the solvent composition can be performed to reduce the suddenness of volume contraction that takes place during surfactant removal and metal nanoparticle consolidation. Specifically, more than one member of each class of organic solvent (*i*.*e*., hydrocarbons, alcohols, amines, and organic acids), can be present in the organic matrix, where the members of each class have boiling points that are separated from one another by a set degree. For example, in some embodiments, the various members of each class can have boiling points that are separated from one another by about 20°C to about 50°C. By using such a solvent mixture, sudden volume changes due to rapid loss of solvent can be minimized during metal nanoparticle consolidation, since the various components of the solvent mixture can be removed gradually over a broad range of boiling points (*e*.*g*., about 50°C to about 200°C).

In some embodiments, at least some of the one or more organic solvents can have a boiling point of about 100°C or greater. In some embodiments, at least some of the one or more organic solvents can have a boiling point of about 200°C or greater. In some embodiments, the one or more organic solvents can have boiling points ranging between about 50°C and about 200°C. Use of high boiling organic solvents can desirably increase the pot life of the printing compositions and limit the rapid loss of solvent, which can lead to cracking and void formation during nanoparticle consolidation. In some embodiments, at least one of the organic solvents can have a boiling point that is higher than the boiling point(s) of the surfactant(s) associated with the metal nanoparticles Accordingly, surfactant(s) can be removed from the metal nanoparticles by evaporation before removal of the organic solvent(s) takes place.

In some embodiments, the organic matrix can contain one or more alcohols. In various embodiments, the alcohols can include monohydric alcohols, diols, triols, glycol ethers *(e.g.,* diethylene glycol and triethylene glycol), alkanolamines *(e.g.,* ethanolamine, triethanolamine, and the like), or any combination thereof. In some embodiments, one or more hydrocarbons can be present in combination with one or more alcohols. As discussed above, it is believed that alcohol and hydrocarbon solvents can passively promote the solubilization of surfactants as they are removed from the metal nanoparticles by Brownian motion and limit their re-association with the metal nanoparticles. Moreover, hydrocarbon and alcohol solvents only weakly coordinate with metal nanoparticles, so they do not simply replace the displaced surfactants in the nanoparticle coordination sphere. Illustrative but non-limiting examples of alcohol and hydrocarbon solvents that can be present in the printing compositions include, for example, light aromatic petroleum distillate (CAS 64742-95-6), hydrotreated light petroleum distillates (CAS 64742-47-8), tripropyleneglycol methyl ether, ligroin (CAS 68551-17-7, a mixture of C₁₀-C₁₃ alkanes), diisopropyleneglycol monomethyl ether, diethyleneglycol diethyl ether, 2-propanol, 2-butanol, t-butanol, 1-hexanol, 2-(2-butoxyethoxy)ethanol, and terpineol. In some embodiments, polyketone solvents can be used in a like manner.

In some embodiments, the organic matrix can contain one or more amines and one or more organic acids. In some embodiments, the one or more amines and one or more organic acids can be present in an organic matrix that also includes one or more hydrocarbons and one or more alcohols. As discussed above, it is believed that amines and organic acids can actively sequester surfactants that have been passively solubilized by hydrocarbon and alcohol solvents, thereby making the surfactants unavailable for re-association with the metal nanoparticles. Thus, an organic solvent that contains a combination of one or more hydrocarbons, one or more alcohols, one or more amines, and one or more organic acids can provide synergistic benefits for promoting the consolidation of metal nanoparticles. Illustrative but non-limiting examples of amine solvents that can be present in the printing compositions include, for example, tallowamine (CAS 61790-33-8), alkyl (C₈-C₁₈) unsaturated amines (CAS 68037-94-5), di(hydrogenated tallow)amine (CAS 61789-79-5), dialkyl (C₈-C₂₀) amines (CAS 68526-63-6), alkyl (C₁₀-C₁₆)dimethyl amine (CAS 67700-98-5), alkyl (C₁₄-C₁₈) dimethyl amine (CAS 68037-93-4), dihydrogenated tallowmethyl amine (CAS 61788-63-4), and trialkyl (C₆-C₁₂) amines (CAS 68038-01-7). Illustrative but non-limiting examples of organic acid solvents that can be present in the printing compositions include, for example, octanoic acid, nonanoic acid, decanoic acid, caprylic acid, pelargonic acid, undecylic acid, lauric acid, tridecylic acid, myristic acid, pentadecanoic acid, palmitic acid, margaric acid, stearic acid, nonadecylic acid, α-linolenic acid, stearidonic acid, oleic acid, and linoleic acid.

In some embodiments, the organic matrix can include more than one hydrocarbon, more than one alcohol, more than one amine, and more than one organic acid. For example, in some embodiments, each class of organic solvent can have two or more members, or three or more members, or four or more members, or five or more members, or six or more members, or seven or more members, or eight or more members, or nine or more members, or ten or more members. Moreover, the number of members in each class of organic solvent can be the same or different. Particular benefits of using multiple members of each class of organic solvent are described hereinafter.

One particular advantage of using multiple members within each class of organic solvent can include the ability to provide a wide spread of boiling points in the printing compositions. By providing a wide spread of boiling points, the organic solvents can be removed gradually as the temperature rises while affecting metal nanoparticle consolidation, thereby limiting volume contraction and disfavoring cracking. By gradually removing the organic solvent in this manner, less temperature control may be needed to affect slow solvent removal than if a single solvent with a narrow boiling point range was used. In some embodiments, the members within each class of organic solvent can have a window of boiling points ranging between about 50°C and about 200°C, or between about 50°C and about 250°C, or between about 100°C and about 200°C, or between about 100°C and about 250°C. In more particular embodiments, the various members of each class of organic solvent can each have boiling points that are separated from one another by at least about 20°C, specifically about 20°C to about 50°C. More specifically, in some embodiments, each hydrocarbon can have a boiling point that differs by about 20°C to about 50°C from other hydrocarbons in the organic matrix, each alcohol can have a boiling point that differs by about 20°C to about 50°C from other alcohols in the organic matrix, each amine can have a boiling point that differs by about 20°C to about 50°C from other amines in the organic matrix, and each organic acid can have a boiling point that differs by about 20°C to about 50°C from other organic acids in the organic matrix. The more members of each class of organic solvent that are present, the smaller the differences become between the boiling points. By having smaller differences between the boiling points, solvent removal can be made more continual, thereby limiting the degree of volume contraction that occurs at each stage. A reduced degree of cracking can occur when four to five or more members of each class of organic solvent are present *(e.g.,* four or more hydrocarbons, four or more alcohols, four or more amines, and four or more organic acids; or five or more hydrocarbons, five or more alcohols, five or more amines, and five or more organic acids), each having boiling points that are separated from one another within the above range.

In order to promote dispensability through the printing heads of additive manufacturing equipment, particularly micron-sized apertures, the printing compositions can desirably have a low maximum particle size. As discussed in further detail below, in some embodiments, the printing compositions can be homogenized to break apart aggregates of metal nanoparticles in order for a low maximum particle size to be realized, or the printing compositions can be passed through a screen or sieve to remove larger particles. Other size-based separation techniques can also be employed in some embodiments. In some embodiments, the printing compositions can have a maximum particle size of about 75 microns or less. In other embodiments, the printing compositions can have a maximum particle size of about 50 microns or less, or about 40 microns or less, or about 30 microns or less, or about 20 microns or less, or about 10 microns or less. The maximum particle size can include agglomerates of metal nanoparticles with themselves and with other components of the printing compositions.

In various embodiments, the metal nanoparticles used in the printing compositions can be about 20 nm or less in size. As discussed above, metal nanoparticles in this size range have fusion temperatures that are significantly lower than those of the corresponding bulk metal and readily undergo consolidation with one another as a result. In some embodiments, metal nanoparticles that are about 20 nm or less in size can have a fusion temperature of about 220°C or below (*e*.*g*., a fusion temperature in the range of about 150°C to about 220°C) or about 200°C or below, which can provide advantages that are noted above. In some embodiments, at least a portion of the metal nanoparticles can be about 10 nm or less in size, or about 5 nm or less in size. In some embodiments, at least a portion of the metal nanoparticles can range between about 1 nm in size to about 20 nm in size, or between about 1 nm in size and about 10 nm in size, or between about 1 nm in size to about 5 nm in size, or between about 3 nm in size to about 7 nm in size, or between about 5 nm in size to about 20 nm in size. In some embodiments, substantially all of the metal nanoparticles can reside within these size ranges. In some embodiments, larger metal nanoparticles can be combined in the printing compositions with metal nanoparticles that are about 20 nm in size or less. For example, in some embodiments, metal nanoparticles ranging from about 1 nm to about 10 nm in size can be combined with metal nanoparticles that range from about 25 nm to about 50 nm in size, or with metal nanoparticles that range from about 25 nm to about 100 nm in size. As further discussed below, micron-scale metal particles or nanoscale particles can also be included in the printing compositions in some embodiments. Although larger metal nanoparticles and micron-scale metal particles may not be liquefiable the low temperatures of their smaller counterparts, they can still become consolidated upon contacting the smaller metal nanoparticles that have been liquefied at or above their fusion temperature, as generally discussed above.

In addition to metal nanoparticles and organic solvents, other additives can also be present in the printing compositions. Such additional additives can include, for example, rheology control aids, thickening agents, micron-scale conductive additives, nanoscale conductive additives, and any combination thereof. Chemical additives can also be present. As discussed hereinafter, the inclusion of micron-scale conductive additives, such as micron-scale metal particles, can be particularly advantageous.

In some embodiments, the printing compositions can contain about 0.01% to about 15% micron-scale metal particles by weight, or about 1% to about 10% micron-scale metal particles by weight, or about 1% to about 5% micron-scale metal particles by weight. Inclusion of micron-scale metal particles in the printing compositions can desirably reduce the incidence of cracking that occurs during consolidation of the metal nanoparticles when forming a contiguous metal trace. Without being bound by any theory or mechanism, it is believed that the micron-scale metal particles can become consolidated with one another as the metal nanoparticles are liquefied and flow between the micron-scale metal particles. In some embodiments, the micron-scale metal particles can range between about 500 nm to about 100 microns in size in at least one dimension, or from about 500 nm to about 10 microns in size in at least one dimension, or from about 100 nm to about 5 microns in size in at least one dimension, or from about 100 nm to about 10 microns in size in at least one dimension, or from about 100 nm to about 1 micron in size in at least one dimension, or from about 1 micron to about 10 microns in size in at least one dimension, or from about 5 microns to about 10 microns in size in at least one dimension, or from about 1 micron to about 100 microns in size in at least one dimension. The micron-size metal particles can contain the same metal as the metal nanoparticles or contain a different metal. Thus, metal alloys can be fabricated by including micron-size metal particles in the printing compositions with a metal differing from that of the metal nanoparticles. Suitable micron-scale metal particles can include, for example, Cu, Ni, Al, Fe, Co, Mo, Ag, Zn, Sn, Au, Pd, Pt, Ru, Mn, Cr, Ti, V, Mg or Ca particles. Non-metal particles such as, for example, Si and B micron-scale particles can be used in a like manner. In some embodiments, the micron-scale metal particles can be in the form of metal flakes, such as high aspect ratio copper flakes, for example. That is, in some embodiments, the printing compositions described herein can contain a mixture of copper nanoparticles and high aspect ratio copper flakes. Specifically, in some embodiments, the printing compositions can contain about 30% to about 90% copper nanoparticles by weight and about 0.01% to about 15% high aspect ratio copper flakes by weight. Other micron-scale metal particles that can be used equivalently to high aspect ratio metal flakes include, for example, metal nanowires and other high aspect ratio particles, which can be up to about 300 microns in length.

In some embodiments, nanoscale conductive additives can also be present in the printing compositions. These additives can desirably provide further structural reinforcement and reduce shrinkage during metal nanoparticle consolidation. Moreover, inclusion of nanoscale conductive additives can increase electrical and thermal conductivity values that can approach or even exceed that of the corresponding bulk metal following nanoparticle consolidation. In some embodiments, the nanoscale conductive additives can have a size in at least one dimension ranging between about 1 micron and about 100 microns, or ranging between about 1 micron and about 300 microns. Suitable nanoscale conductive additives can include, for example, carbon nanotubes, graphene, and the like. When present, the printing compositions can contain about 1% to about 10% nanoscale conductive additives by weight, or about 1% to about 5% nanoscale conductive additives by weight. Additional substances that can also optionally be present include, for example, flame retardants, UV protective agents, antioxidants, carbon black, graphite, fiber materials (*e*.*g*., chopped carbon fiber materials), and the like.

As referenced above, the present disclosure provides additive manufacturing processes in which a first printing composition containing metal nanoparticles is deposited in a desired shape along with a second printing composition containing a dielectric material, and the metal nanoparticles are then at least partially fused together to form a metal trace in the printed object by heating. The second printing composition containing the polymer or other dielectric material can be deposited along with or before the metal nanoparticles, and heating to consolidate the metal nanoparticles together can take place below a softening temperature of the polymer or other dielectric material. In illustrative embodiments, the contiguous metal traces in the printed object can define an antenna, wherein the particular shape of the antenna is not considered to be particularly limited. Moreover, in some embodiments, the polymer or other dielectric material can be removed from object *(e.g.,* by solvent dissolution, thermolysis, melting or the like) to leave behind one or more dielectric free metal traces.

The polymer utilized as dielectric material is at least one of polyketones, polystrenes such as acrylonitrile-butadiene-styrene copolymer, polyetheretherketones, polyamides, polyolefins such as polyethylene or polypropylene, polyesters, polyurethanes, polyacrylonitriles, polycarbonates, polyetherimines, polyethyleneimine, polyethylene terephthalate, polyvinyl chloride, copolymers thereof, and mixtures thereof.

In more particular embodiments, the polymer can be a polyetherimine or a polycarbonate, and in still more particular embodiments, the polymer can be a polyetherimine. Polyetherimine polymers can be especially desirable due to their high strength, thermal stability and radiation resistance, which can make them well suitable for aerospace applications. In some embodiments, a mixture of polymers can be present in combination with one another.

In some embodiments, the first and second printing compositions can be deposited sequentially from the same print head of an additive manufacturing apparatus, and in other embodiments, the first and second printing compositions can be deposited from separate print heads. . Furthermore, the printing compositions described herein can be deposited using conventional additive manufacturing equipment and apparatuses.

In illustrative embodiments, at least a portion of the second printing composition containing the polymer or other dielectric material can be deposited before depositing the first printing composition containing the metal nanoparticles. For example, the second printing composition can be deposited to form a base structure containing the polymer or dielectric material, and the first printing composition can then place metal nanoparticles in or on the base structure in a desired pattern. The second printing composition is deposited above the softening temperature of the dielectric material, which is then cooled below the softening temperature before depositing the first printing composition.

In either case, after depositing the metal nanoparticles and consolidating to form one or more contiguous metal traces, a second portion of the second printing composition can then be deposited in some embodiments *(e.g.,* to complete the fabrication of the object). In some instances, the second printing composition can be deposited upon the one or more contiguous metal traces. These processes can be repeated iteratively as needed to build the object into a desired shape with multiple contiguous metal traces being disposed therein. Depositing the metal nanoparticles after depositing at least a portion of the polymer or other dielectric material allows the metal nanoparticles to be fused into one or more contiguous metal traces within or upon a base structure of the polymer below the polymer's softening temperature, thereby not deforming the object during fabrication. After consolidating the metal nanoparticles together, additional deposition of the polymer or other dielectric material can then take place without significantly changing the structure of the resulting contiguous metal traces.

Consolidation of the metal nanoparticles takes place in conjunction with the deposition process, by maintaining the object below the softening temperature of the dielectric material but above the fusion temperature. In such embodiments, subsequently deposited metal nanoparticles can become consolidated with those initially deposited in forming the one or more contiguous metal traces.

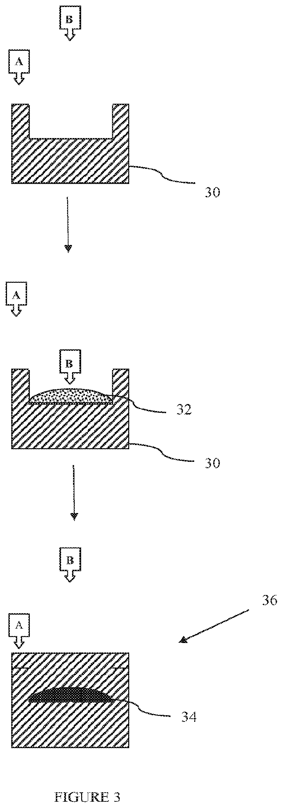

In some embodiments, the first printing composition and the second printing composition can be deposited sequentially with respect to one another. Such a process is shown in FIGURE 3.

FIGURE 3 shows an illustrative schematic of an additive manufacturing process in which metal nanoparticles are deposited and consolidated following deposition of a polymer material. As shown in FIGURE 3, a first printing composition containing metal nanoparticles is deposited from print head B, and a second printing composition containing a polymer is deposited from print head A. Although FIGURE 3 has depicted separate print heads, it is to be recognized that sequential deposition can also take place from a common print head. Print head A is used to deposit the polymer to define base structure 30. After the polymer has been cooled below its softening temperature, metal nanoparticles 32 can be deposited in a desired pattern from print head B. The base structure 30 remains above the fusion temperature of metal nanoparticles 32, consolidation of the metal nanoparticles can take place in conjunction with the deposition process. As shown a second portion of polymer can then be deposited upon base structure 30 and/or contiguous metal trace 34 to complete the fabrication of object 36.

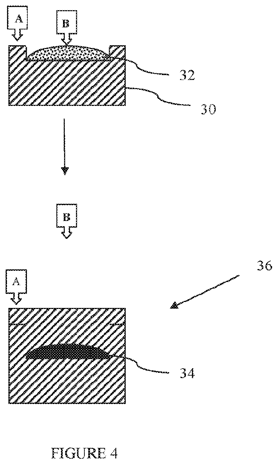

In some or other embodiments, the at least a portion of the first printing composition and at least a portion of the second printing composition can be deposited concurrently with one another. Specifically, the first printing composition and the second printing composition can be deposited at different locations (*i*.*e*., spaced apart locations) of the object from separate print heads. Such a process is shown in FIGURE 4.

FIGURE 4 shows an illustrative schematic of an additive manufacturing process of an object in which metal nanoparticles and a polymer material are deposited at separate locations. As in FIGURE 3, polymer can be deposited from print head A to initially deposit a portion of base structure 30. Unlike FIGURE 3, however, print head A can continue to deposit polymer upon base structure 30 while metal nanoparticles 32 are being also deposited from print head B. Consolidation of metal nanoparticles 32 can occur in conjunction with this process. After contiguous metal trace 34 has been defined through metal nanoparticle consolidation, deposition of polymer from print head A can be used to complete the fabrication of object 36.

Although FIGURES 3 and 4 have depicted objects containing single layers of polymer and contiguous metal traces, it is to be recognized that multi-layer objects can also be fabricated in some embodiments. Specifically, in some embodiments, the various processing steps described above can be repeated iteratively to define multi-layer objects. In some embodiments, the first printing composition and the second printing composition can be deposited in alternating layers within the object. The alternating layers need not necessarily be planar with one another. For example, in some embodiments, contiguous metal traces can interpenetrate through multiple polymer layers.

In some or other embodiments, the additive manufacturing processes of the present disclosure can be applied to produce one or more contiguous metal traces that have a three-dimensional shape. In still more specific embodiments, the additive manufacturing processes can be applied to produce contiguous metal traces that are curved.

In some embodiments, the additive manufacturing processes of the present disclosure can be used to fabricate an object in which the one or more contiguous metal traces define an antenna. As discussed above, suitable antenna structures are not considered to be particularly limited, and a wide breadth of antenna shapes can be fabricated by applying the additive manufacturing processes disclosed herein. Fractal three-dimensional antennas can be produced both on planar and non-planar substrates in some embodiments. Three-dimensional spiral antennas, spherical helical antennas, conical helical antennas, Archimedian spiral resonators, and conical log spiral antennas can also be produced by applying the disclosure herein.

## Claims

1. An additive manufacturing process comprising:
providing a first printing composition comprising a plurality of metal nanoparticles and a second printing composition comprising a dielectric material, wherein the plurality of metal nanoparticles is selected from a group consisting of tin nanoparticles, copper nanoparticles, aluminum nanoparticles, palladium nanoparticles, silver nanoparticles, iron nanoparticles, cobalt nanoparticles, nickel nanoparticles, titanium nanoparticles, zirconium nanoparticles, hafnium nanoparticles, and tantalum nanoparticles and the dielectric material comprises at least one of polyketones, polystrenes, acrylonitrile-butadiene-styrene copolymer, polyetheretherketones, polyamides, polyolefins, polyethylene, polypropylene, polyesters, polyurethanes, polyacrylonitriles, polycarbonates, polyetherimines, polyethyleneimine, polyethylene terephthalate, polyvinyl chloride, polyetherimine, polycarbonate, and polyetherimine;
depositing at least a portion of the second printing composition above a softening temperature of the dielectric material to form an object having a desired shape;
cooling the first portion of the object below the softening temperature and above a fusion temperature of the metal nanoparticles before depositing the first printing composition;
depositing the first printing composition on the first portion of the object, the metal nanoparticles being unconsolidated with one another while being deposited; and
maintaining the deposited first printing composition above a fusion temperature of the metal nanoparticles and below a softening temperature of the dielectric material during depositing the first printing composition to define one or more contiguous metal traces in the object, the one or more contiguous metal traces comprising metal nanoparticles that have been at least partially fused together with one another in a defined shape.

2. The additive manufacturing process of claim 1, wherein the metal nanoparticles comprise copper nanoparticles.

3. The additive manufacturing process of claim 1, wherein a surfactant coating is present upon a surface of the metal nanoparticles, the surfactant coating comprising one or more surfactants.

4. The additive manufacturing process of claim 1, further comprising:
depositing at least a portion of the second printing composition after defining the one or more contiguous metal traces in the object.

5. The additive manufacturing process of claim 4, wherein at least a portion of the second printing composition is deposited upon the one or more contiguous metal traces in the object.

6. The additive manufacturing process of claim 1, wherein the first printing composition and the second printing composition are deposited concurrently at different locations within the object, or in alternating layers within the object.

7. The additive manufacturing process of claim 1, wherein the one or more contiguous metal traces have a three-dimensional shape.

8. The additive manufacturing process of claim 7, wherein the one or more contiguous metal traces are curved.

9. The additive manufacturing process of claim 1, wherein the one or more contiguous metal traces define an antenna.

10. The additive manufacturing process of claim 1, further comprising:
removing the dielectric material from the object to leave behind one or more dielectric-free contiguous metal traces.

## Patentansprüche

1. Verfahren zur additiven Fertigung, umfassend:
Bereitstellen einer ersten Druckzusammensetzung, die eine Vielzahl von Metall-Nanopartikeln aufweist, und einer zweiten Druckzusammensetzung, die ein dielektrisches Material aufweist, wobei die Vielzahl der Metall-Nanopartikel aus einer Gruppe ausgewählt sind, die aus Zinn-Nanopartikeln, Kupfer-Nanopartikeln, Aluminium-Nanopartikeln, Palladium-Nanopartikeln, Silber-Nanopartikeln, Eisen-Nanopartikeln, Kobalt-Nanopartikeln, Nickel-Nanopartikeln, Titan-Nanopartikeln, Zirkonium-Nanopartikel, Hafnium-Nanopartikeln und Tantal-Nanopartikeln besteht, und wobei das dielektrische Material mindestens eines der folgenden Materialien umfasst: Polyketone, Polystyrole, Acrylnitril-Butadien-Styrol-Copolymer, Polyetheretherketone, Polyamide, Polyolefine, Polyethylen, Polypropylen, Polyester, Polyurethane, Polyacrylnitrile, Polycarbonate, Polyetherimine, Polyethylenimin, Polyethylenterephthalat, Polyvinylchlorid, Polyetherimin, Polycarbonat und Polyetherimin;
Abscheiden mindestens eines Teils der zweiten Druckzusammensetzung oberhalb einer Erweichungstemperatur des dielektrischen Materials, um einen Gegenstand mit einer gewünschten Form zu bilden;
Abkühlen des ersten Teils des Gegenstands bis unter die Erweichungstemperatur und über eine Schmelztemperatur der Metall-Nanopartikel vor dem Abscheiden der ersten Druckzusammensetzung;
Abscheiden der ersten Druckzusammensetzung auf dem ersten Teil des Gegenstands, wobei die Metall-Nanopartikel während des Abscheidens nicht miteinander verfestigt sind; und
Halten der abgeschiedenen ersten Druckzusammensetzung oberhalb einer Schmelztemperatur der Metall-Nanopartikel und unterhalb einer Erweichungstemperatur des dielektrischen Materials während des Abscheidens der ersten Druckzusammensetzung, um eine oder mehrere zusammenhängende Metallbahnen in dem Gegenstand zu bilden, wobei die eine oder die mehreren zusammenhängenden Metallbahnen Metall-Nanopartikel aufweist bzw. aufweisen, die zumindest teilweise zu einer definierten Form miteinander verschmolzen worden sind.

2. Verfahren zur additiven Fertigung nach Anspruch 1, wobei die Metall-Nanopartikel Kupfer-Nanopartikel aufweisen.

3. Verfahren zur additiven Fertigung nach Anspruch 1, wobei eine Tensidbeschichtung auf einer Oberfläche der Metall-Nanopartikel vorhanden ist, wobei die Tensidbeschichtung ein oder mehrere Tenside aufweist.

4. Verfahren zur additiven Fertigung nach Anspruch 1, darüber hinaus umfassend:
Abscheiden von zumindest einem Teil der zweiten Druckzusammensetzung nach dem Bilden der einen oder der mehreren zusammenhängenden Metallbahnen in dem Gegenstand.

5. Verfahren zur additiven Fertigung nach Anspruch 4, wobei zumindest ein Teil der zweiten Druckzusammensetzung auf der einen oder den mehreren zusammenhängenden Metallbahnen in dem Gegenstand abgeschieden wird.

6. Verfahren zur additiven Fertigung nach Anspruch 1, wobei die erste Druckzusammensetzung und die zweite Druckzusammensetzung gleichzeitig an verschiedenen Stellen innerhalb des Gegenstands oder in abwechselnden Schichten innerhalb des Gegenstands abgeschieden werden.

7. Verfahren zur additiven Fertigung nach Anspruch 1, wobei die eine oder die mehreren zusammenhängenden Metallbahnen eine dreidimensionale Form hat bzw. haben.

8. Verfahren zur additiven Fertigung nach Anspruch 7, wobei die eine oder die mehreren zusammenhängenden Metallbahnen gekrümmt ist bzw. sind.

9. Verfahren zur additiven Fertigung nach Anspruch 1, wobei die eine oder die mehreren zusammenhängenden Metallbahnen eine Antenne bilden.

10. Verfahren zur additiven Fertigung nach Anspruch 1, darüber hinaus umfassend:
Entfernen des dielektrischen Materials von dem Gegenstand, um eine oder mehrere zusammenhängende Metallbahnen zu hinterlassen, die kein Dielektrikum aufweisen.

## Revendications

1. Procédé de fabrication additive comprenant :
la fourniture d'une première composition d'impression comprenant une pluralité de nanoparticules de métal et une deuxième composition d'impression comprenant un matériau diélectrique, sachant que la pluralité de nanoparticules de métal est sélectionnée dans un groupe constitué par des nanoparticules d'étain, des nanoparticules de cuivre, des nanoparticules d'aluminium, des nanoparticules de palladium, des nanoparticules d'argent, des nanoparticules de fer, des nanoparticules de cobalt, des nanoparticules de nickel, des nanoparticules de titane, des nanoparticules de zirconium, des nanoparticules de hafnium, et des nanoparticules de tantale et le matériau diélectrique comprend au moins un élément parmi les polycétones, les polystyrènes, le copolymère d'acrylonitrile-butadiène-styrène, les polyétheréthercétones, les polyamides, les polyoléfines, le polyéthylène, le polypropylène, les polyesters, les polyuréthanes, les polyacrylonitriles, les polycarbonates, les polyétherimines, la polyéthylèneimine, le téréphtalate de polyéthylène, le chlorure de polyvinyle, la polyétherimine, le polycarbonate, et la polyétherimine ;
le dépôt d'au moins une partie de la deuxième composition d'impression au-dessus d'une température de ramollissement du matériau diélectrique pour former un objet ayant une forme désirée ;
le refroidissement de la première partie de l'objet sous la température de ramollissement et au-dessus de la température de fusion des nanoparticules de métal avant le dépôt de la première composition d'impression ;
le dépôt de la première composition d'impression sur la première partie de l'objet, les nanoparticules de métal étant non consolidées les unes avec les autres pendant qu'elles sont déposées ; et
le maintien de la première composition d'impression déposée au-dessus d'une température de fusion des nanoparticules de métal et sous une température de ramollissement du matériau diélectrique pendant le dépôt de la première composition d'impression pour définir une ou plusieurs traces de métal contiguës dans l'objet, l'une ou les plusieurs traces de métal contiguës comprenant des nanoparticules de métal qui ont été au moins en partie fusionnées les unes avec les autres dans une forme définie.

2. Le procédé de fabrication additive de la revendication 1, sachant que les nanoparticules de métal comprennent des nanoparticules de cuivre.

3. Le procédé de fabrication additive de la revendication 1, sachant qu'un revêtement de tensioactif est présent sur une surface des nanoparticules de métal, le revêtement de tensioactif comprenant un ou plusieurs tensioactifs.

4. Le procédé de fabrication additive de la revendication 1, comprenant en outre :
le dépôt d'au moins une partie de la deuxième composition d'impression après la définition de l'une ou des plusieurs traces de métal contiguës dans l'objet.

5. Le procédé de fabrication additive de la revendication 4, sachant qu'au moins une partie de la deuxième composition d'impression est déposée sur l'une ou les plusieurs traces de métal contiguës dans l'objet.

6. Le procédé de fabrication additive de la revendication 1, sachant que la première composition d'impression et la deuxième composition d'impression sont déposées concurremment à différents endroits à l'intérieur de l'objet, ou dans des couches alternantes à l'intérieur de l'objet.

7. Le procédé de fabrication additive de la revendication 1, sachant que l'une ou les plusieurs traces de métal contiguës ont une forme tridimensionnelle.

8. Le procédé de fabrication additive de la revendication 7, sachant que l'une ou les plusieurs traces de métal contiguës sont courbes.

9. Le procédé de fabrication additive de la revendication 1, sachant que l'une ou les plusieurs traces de métal contiguës définissent une antenne.

10. Le procédé de fabrication additive de la revendication 1, comprenant en outre :
l'enlèvement du matériau diélectrique de l'objet pour laisser une ou plusieurs traces de métal contiguës exemptes de diélectrique.
